(19)

Europäisches
Patentamt
European
Patent Office
Office européen
des brevets

(11) **EP 2 819 310 A1**

(12) **EUROPEAN PATENT APPLICATION**

(43) Date of publication:
**31.12.2014  Bulletin 2015/01**

(51) Int Cl.:
***H03M 13/11*** *(2006.01)*

(21) Application number: **13305884.2**

(22) Date of filing: **26.06.2013**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **ALCATEL LUCENT
92100 Boulogne-Billancourt (FR)**

(72) Inventors:
• **Razzetti, Luca Gabriele
  20871 VIMERCATE (MB) (IT)**
• **Costantini, Carlo
  20871 VIMERCATE (MB) (IT)**

• **Pepe, Marianna
  20871 VIMERCATE (MB) (IT)**
• **Gavioli, Giancarlo
  20871 VIMERCATE (MB) (IT)**

(74) Representative: **Colombo, Stefano Paolo et al
MARCHI & PARTNERS S.r.l.
Via G.B. Pirelli, 19
20124 Milano (IT)**

Remarks:
Amended claims in accordance with Rule 137(2)
EPC.

(54) **Iterative error decoder with cascaded decoding blocks and a feedback decoding block**

(57)   It is disclosed a forward error correction decoder for a network element of a communication network. The decoder comprises a first decoding stage configured to receive an input data block, the first decoding stage comprising a plurality of decoding units connected in cascade, each of said decoding units being configured to perform one iteration of a forward error correction decoding procedure on said input data block. The first decoding stage is further configured to output an output data block.

The decodes also comprises a second decoding stage comprising a further decoding unit configured to: receive the output data block in case the output data block is not correct; and perform a number of further iterations of the forward error correction decoding procedure on the output data block until a termination condition is fulfilled, the number of further iterations being equal to or higher than 1.

Fig. 2

EP 2 819 310 A1

## Description

### Technical field

The present invention generally relates to the field of communication networks. In particular, the present invention relates to a Forward Error Correction (FEC) decoder for a network element of a Wavelength Division Multiplexing (WDM) communication network.

### Background art

As known, Forward Error Correction (FEC) is a technique used for detecting and possibly correcting errors in digital data transmissions between network elements of a digital communication network, in particular a Wavelength Division Multiplexing (WDM) communication network.

According to the FEC technique, at the transmitting side an encoder encodes the data in a redundant way according to an error correcting code, while at the receiving side a decoder uses the redundancy added to the transmitted data to detect, and possibly to correct, errors.

Among the error correcting codes, the Low Density Parity Check (LDPC) code is widely used in state of the art WDM communication networks. The LDPC code is a linear (n, k) block code defined by a sparse parity-check matrix, often indicated as H and by a rate r=k/n.

A linear (n, k) block code like the LDPC code assigns a codeword of length n to an input data block of length k, with n>k. The input data block and the codeword are made of transmission symbols, each symbol being represented by a finite number of bits.

It is assumed in the following, for sake of simplicity, that each transmission symbol is represented by a single bit, which takes the value 0 or 1.

In this case, when a (n, k) block code is applied, an input data block of k bits is mapped into a corresponding codeword of n bits. Each codeword of n bits contains k data bits and n-k parity-checks bits.

The parity-check matrix H has n columns and n-k rows, and each row represents a parity check. Indeed, a valid codeword $\underline{c}$ (which is, under the assumption above, an array of n bits) satisfies the following condition:

$$H\underline{c}=\underline{0}$$

i.e. a valid codeword multiplied by the parity-check matrix gives an array of n-k zeros.

When data are to be transmitted between two network elements, a transmitter at the source element applies the LDPC code to the data and uses the output of the encoder to modulate a carrier in order to generate a signal that propagates over the physical transmission medium. The BPSK modulation scheme is typically used for modulating a carrier with binary symbols. At the receiving element, the signal is typically demodulated and then decoded in order to retrieve the transmitted data. At the output of the demodulator, the received symbols may be in the form of a sequence of real values each having a sign.

As known, an LDPC code may be decoded according to a hard decision decoding scheme or a soft decision decoding scheme.

When hard decision decoding is applied, a binary decision is taken prior to the actual decoding operation. In particular, each received symbol is processed and compared to a decision threshold, in order to decide whether it is a 0 or a 1. The decision threshold may be set to zero and it may be decided that the symbol is 0 if positive and 1 if negative. Then, the hard decided symbols are sent to the decoder as a sequence of n-symbol data blocks.

When soft decision decoding is applied, the received symbols may undergo a quantization process. According to this process, a number of decision thresholds are determined as discretized values ranging between a maximum quantization value and a minimum quantization value. For instance the decision thresholds may range between -7 and 7 and each threshold may thus be represented by 4 bits. Each received symbol is compared with the decision thresholds and then associated to the closest decision threshold. Accordingly, each received symbol is associated to the bits representing the corresponding closest decision threshold. These quantized and digitized symbols are then sent to the decoder as a sequence of n-symbol data blocks. When soft decision decoding is applied, no decision is taken before decoding and the quantized and digitized symbols at the output of the demodulator are used for decoding. The bits digitizing the quantized demodulated symbols are typically referred to as soft information associated to the symbols. The soft information may comprise other information which will not de described in the following as they are not relevant to the present description.

The n-symbol data blocks at the input of the decoder when hard decision decoding or soft decision decoding is applied will be in both cases referred to simply as "input data blocks" or simply "data blocks". In case of hard decision, each data block comprises the hard decided bits associated to n received symbols, while in case soft decision is used, each data block comprises the soft information associated to n received symbols.

In both cases of hard decision and soft decision, FEC decoding is typically an iterative procedure. An iterative procedure for decoding of an LDPC FEC code is disclosed in B. Vasic, I.B. Djordjevic, and R.K. Kostuk, "Low-density parity check codes and iterative decoding for long-haul optical communication systems," J. Lightwave Technol., vol. 21, no. 2, pp.438-446.

Each data block at the input of the FEC decoder is processed in order to generate a sequence of decoded symbols and to perform, among other operations, all the parity checks on these decoded symbols. If the parity checks are satisfied (i.e. the decoded symbols form a valid codeword) or if a pre-determined, fixed number of iterations has been reached, the procedure is terminated. Otherwise, the procedure is iterated. In other words, at each iteration, the hard decided symbols (in case of hard decision) or the soft information (in case of soft decision) of a data block are used for generating a sequence of decoded symbols and performing the parity checks, and then they are updated for the next iteration.

Typically the iterative FEC decoding is completed when the pre-determined fixed number of iterations is performed. The pre-determined fixed number of iterations is typically chosen so as to achieve a given decoding performance. The procedure of iterative FEC decoding is known and hence it will not be described in greater detail in the following.

Iterative FEC decoding is typically implemented according to two alternative schemes. A first scheme provides a serial implementation of the FEC decoder, in that a fixed number of decoding units are placed in series. Each decoding unit performs a single decoding iteration, which comprises performing all the parity checks, updating the hard decided bits and/or the soft information and outputting the results of the checks. The number of decoding units is equal to the number of iterations. A second scheme provides a parallel implementation of the FEC decoder, in that a plurality of decoding units are placed in parallel. In this case, the decoder is able to process a plurality of received data blocks in parallel. Each decoding unit processes a different received data block and is capable of performing a pre-determined fixed number of iterations on the processed data block. In other words, each received data block remains in the same decoding unit until a pre-determined fixed number of iterations is performed.

## Summary of the invention

Typically, for LDPC codes, the Bit Error Rate (BER) steadily decreases as the Signal-to-Noise Ratio (SNR) increases. Moreover, performances improve (i.e. the BER curve as a function of the SNR becomes steeper and steeper) as the number of iterations increases. However, there is a point after which the BER curve does not fall as quickly as before; in other words, there is a region in which performance flattens. This region is called the error floor region.

The inventors noticed that there is a strong demand for high speed WDM network implementations (e.g. moving from 10 Gbit/s networks to 100/400/500 Gbit/s networks), which require an error floor below $10^{-15}$. As known, the so called floorless LPDC codes allow achieving this BER performance. However, the inventors verified that with a floorless LDPC code a fixed number of iterations are needed for decoding the received data up to the required performance.

Moreover, the inventors perceived that for high speed WDM network implementations, the scheme involving a series of decoding units is typically used as it allows minimizing the layout of the decoder and reducing connectivity issues within the silicon device on which the decoder is implemented.

Disadvantageously, with the series scheme described above, a fixed number of iterations per n-symbol data block results in a fixed number of decoding units on the silicon device and hence in a fixed amount of complexity and power consumption. This may be very inefficient.

The inventors noticed that for an LDPC code implementation, a low number of iterations is typically necessary to decode a data block, while only very few data blocks require an exceptionally high number of iteration. Therefore, an implementation providing a fixed number of iterations per data block must necessarily contemplate the possibility that the block is corrected after a possibly high number of iterations. Hence, the number of iterations, and, consequently, the number of decoding units over the decoder's silicon device, is often overestimated. This results in a waste of silicon area used for the decoder's device. Moreover, the fixed number of decoding units consumes the same amount of power for each data block, even if the block is corrected with a minimum number of iterations. Hence, also power is inefficiently wasted for most of the data blocks.

In view of the above, it is an object of the present invention to provide a forward error correction decoder which allows overcoming the drawbacks above. In particular, it is an object of the present invention to provide a forward error correction decoder which allows reducing the amount of the required silicon area and the power consumption of the decoder's device.

According to a first aspect, the present invention provides a forward error correction decoder for a network element of a communication network, the forward error correction decoder comprising:

- a first decoding stage configured to receive an input data block, the first decoding stage comprising a plurality of decoding units connected in cascade, each of the decoding units being configured to perform one iteration of a forward error correction decoding procedure on the input data block, the first decoding stage being further configured to output an output data block; and

- a second decoding stage comprising a further decoding unit configured to:

  - receive the output data block in case the output data block is not correct; and
  - perform a number of further iterations of the forward error correction decoding procedure on the output data block until a termination condition is fulfilled, the number of further iterations being equal to or higher than 1.

Preferably the forward error correction decoder comprises a first queue and a second queue. Preferably, the first decoding stage is configured to send decoded symbols of the output data block to the first queue in case the output data block is correct, and to send soft information of the output data block to the second queue in case the output data block is not correct, the second queue having an output configured to be connected to the second decoding stage.

Alternatively, the first decoding stage is configured to send decoded symbols of the output data block to the first queue in case the output data block is correct, and to send the decoded symbols of the output data block to the second queue in case the output data block is not correct, the second queue having an output configured to be connected to the second decoding stage.

Preferably, the forward error correction decoder comprises a scheduler configured to command switching an input and an output of the second decoding stage between a first configuration and a second configuration, wherein:

- the first configuration provides for connecting the input of the second decoding stage to the second queue and the output of the second decoding stage to the first queue; and
- the second configuration provides for retroactively connecting the output of the second decoding stage to the input of the second decoding stage.

Profitably, the scheduler is configured to check whether the termination condition is fulfilled and, in case the termination condition is fulfilled, to command switching the input and the output of the second decoding stage from the second configuration to the first configuration.

Preferably, the scheduler is connected to the second queue and to the second decoding stage and it is further configured to

- receive an information on a filling status of the second queue from the second queue;
- receive a command from the second decoding stage each time the further decoding unit performs one further iteration; and
- on the basis of the filling status and the command, check whether the termination condition is fulfilled by:

  - checking whether at a current further iteration performed by the further decoding unit the output data block is correct; and/or
  - checking whether the second queue has reached a threshold filling level; and/or
  - checking whether a maximum elaboration time elapsed during performing the number of further iterations.

According to a second aspect, the present invention provides a receiver for a network element of a communication network comprising the forward error correction decoder as set forth above.

According to a third aspect, the present invention provides a network element of a communication network comprising a receiver as set forth above.

According to a fourth aspect, the present invention provides a method for decoding an input data block encoded through a forward error correction code, the method comprising:

a) at a plurality of decoding units of a first decoding stage, receiving the input data block, performing a plurality of cascaded iterations of a forward error correction decoding procedure on the input data block (B), and outputting an output data block; and

b) at a further decoding unit of a second decoding stage, receiving the output data block in case the output data block is not correct; and performing a number of further iterations of the forward error correction decoding procedure on the output data block until a termination condition is fulfilled, the number of further iterations being equal to or higher than 1.

Preferably, the method further comprises sending decoded symbols of the output data block to a first queue in case the output data block is correct, and, between step a) and step b), sending soft information of the output data block to a second queue in case the output data block is not correct, wherein at step b) receiving comprises receiving the soft information of the output data block from the second queue.

Alternatively, the method further comprises sending decoded symbols of the output data block to a first queue in case the output data block is correct, and between step a) and step b), sending the decoded symbols of the output data block to a second queue in case the output data block is not correct, wherein at step b) receiving comprises receiving the decoded symbols of the output data block from the second queue.

Preferably, the method comprises, at a scheduler connected to the second queue and to the second decoding stage, receiving an information on a filling status of the second queue from the second queue, receiving a command from the second decoding stage each time one further iteration is performed and checking whether the termination condition is fulfilled, checking comprising:

- checking whether at a current further iteration performed by the further decoding unit the output data block is correct; and/or
- checking whether the second queue has reached a threshold filling level; and/or
- checking whether a maximum elaboration time elapsed during performing the number of further iterations.

Preferably, the method comprises, when the termination condition is fulfilled, sending decoded symbols of the output data block generated at the second decoding stage to the first queue.

Preferably, the method further comprises, before step b), in case the output data block is not correct, leaving a number of cells empty within the first queue.

Preferably, the method comprises, at the first queue, storing the decoded symbols of the output data block generated at the second decoding stage into the empty cells of the first queue.

## Brief description of the drawings

Embodiments of the invention will be better understood by reading the following detailed description, given by way of example and not of limitation, to be read with reference to the accompanying drawings, wherein:

- Figure 1 is a histogram showing the fraction of corrected n-symbol data blocks versus the number of iterations for an exemplary LDPC code;
- Figure 2 is an exemplary block scheme of a forward error correction decoder according to a preferred embodiment of the present invention;
- Figure 3 shows a portion of the block scheme of Figure 2 for illustrating the operation of the decoder according to the preferred embodiment of the present invention; and
- Figure 4 is a graph showing a BER curve versus the SNR for a state of the art FEC decoder comprising a fixed number of decoding units and a BER curve versus the SNR for a FEC decoder according to the present invention.

## Detailed description of preferred embodiments of the invention

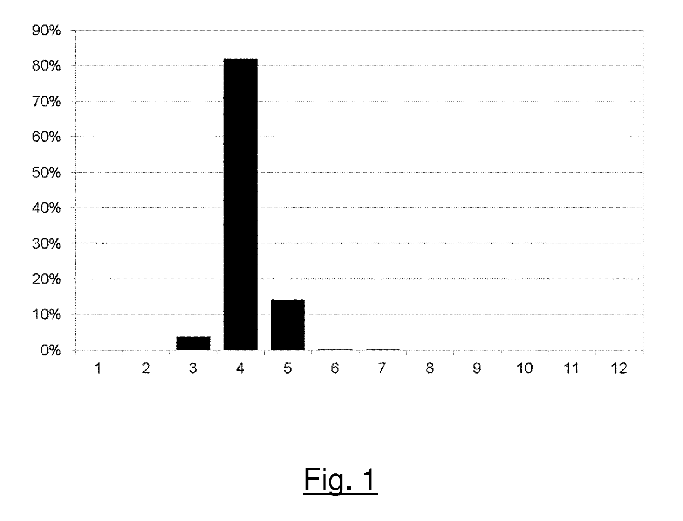

Figure 1 shows a histogram representing the fraction of corrected n-symbol data blocks versus the number of iterations needed to correct the data blocks for an exemplary LDPC code. In particular, the considered error correcting code is a floorless LDPC. The considered code can correct errors with output BER < $10^{-15}$ at SNR=2.6 dB by means of a soft decision iterative decoder. As shown, after the first and second iterations, almost all data blocks still contain errors. However, at the third, fourth and fifth iteration most of the received data blocks are corrected. At the subsequent iterations (up to the twelfth iteration in the histogram of Figure 1), a very low number of data blocks remain to be corrected. The n-symbol data blocks requiring more than 5 iterations are about 0.1 %. However, to correct all the n-symbol data blocks up to the required output BER performance 12 iterations are necessary.

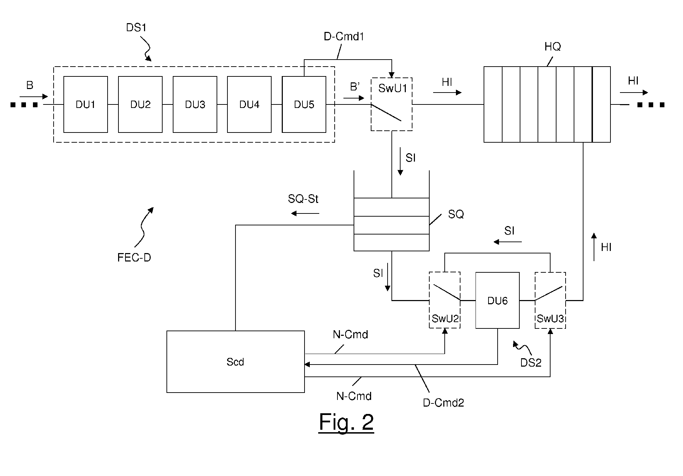

Figure 2 shows an exemplary block scheme of a forward error correction decoder (in the following referred to as simply "FEC decoder") FEC-D according to a preferred embodiment of the present invention. The FEC decoder FEC-D is comprised within a receiver for a network element of a communication network, for instance a WDM communication network. The other components of the receiver will not be described herein after since they are not relevant for the present description. The FEC decoder FEC-D according to the present invention is preferably configured to decode data that have been encoded by a FEC code. Preferably, the FEC code is an LDPC code.

The FEC decoder FEC-D preferably comprises a first decoding stage DS1 comprising a plurality of decoding units DU1, DU2, ..., DU5. The decoding units DU1, DU2, ..., DU5 are preferably connected in cascade. The FEC decoder FEC-D further preferably comprises a first switching unit SwU1 whose input is connected to the output of the last decoding unit DU5 within the first decoding stage DS1. The input of the first decoding stage DS1 corresponds to the input of the FEC decoder.

The FEC decoder FEC-D further preferably comprises a first queue HQ and a second queue SQ.

The input of the first switching unit SwU1 may be connected to an input of the first queue HQ and/or to the input of the second queue SQ. The first switching unit SwU1 is operated by a command coming from the last decoding unit DU5 of first decoding stage DS1, which is represented by the arrow labeled by "D-cmd1" in Figure 2, as it will be described in greater detail in the following.

The output of the first queue HQ corresponds to the output of the FEC decoder FEC-D.

Further, the FEC decoder FEC-D preferably comprises a scheduler Scd, a second switching unit SwU2, a second decoding stage DS2 and a third switching unit SwU3. The second decoding stage DS2 preferably comprises a further decoding unit DU6.

The second queue SQ has an output connected to an input of the second switching unit SwU2. Moreover the second queue SQ has a further output connected to the input of the scheduler Scd, for sending information about a filling status of the second queue SQ, as it will be described in greater detail in the following. The output of the second switching unit SwU2 is connected to the input of the second decoding stage DS2. The output of the second decoding stage DS2 is connected to the input of the third switching unit SwU3. A further input of the second switching unit SwU2 may be connected, through a feed-back loop, to an output of the third switching unit SwU3. A further output of the third switching unit SwU3 is connected to a further input of the first queue HQ.

The second switching unit SwU2 and the third switching unit SwU3 are preferably operated by a command from the scheduler Scd (represented by the arrows labeled "N-cmd in Figure 2). In particular, the input of the second switching unit SwU2 may be switched so as to connect the output of the second queue SQ to the input of the second decoding stage DS2 or to retroactively connect the output of the second decoding stage DS2 to the input of the second decoding stage DS2 via the third switching unit SwU3. Correspondingly, the output of the third decoding unit SwU3 may be switched so as to connect the output of the second decoding stage DS2 to the further input of the first queue HQ or to retroactively connect the output of the second decoding stage DS2 to the input of the second decoding stage DS2 via the second switching unit SwU2.

Moreover, preferably, operation of the scheduler Scd is further controlled by a command coming from the further decoding unit DU6 of the second decoding stage DS2, which is represented by the arrow labeled by "D-cmd2" in Figure 2, as it will be described in greater detail herein after.

According to the preferred embodiment of the present invention, each decoding unit DU1, ..., DU5 and the further decoding unit DU6 are configured to perform known operations related to one iteration of an iterative soft decision FEC decoding procedure for FEC decoding a sequence of input data blocks B encoded according to the considered FEC code.

According to a further embodiment of the present invention, each decoding unit DU1, ..., DU5 and the further decoding unit DU6 are configured to perform known operations related to one iteration of an iterative hard decision FEC decoding procedure for FEC decoding a sequence of input data blocks B encoded according to the considered FEC code.

In case the FEC code is an LDPC code, the operations of each decoding unit comprise performing the parity checks, as described above.

For both the embodiments, the known operations of a decoding unit will not be described in greater detail in the following.

The last decoding unit DU5 of the first decoding stage DS1 is configured to provide an output data block B' for each input data block B, as it will be described in greater detail herein after. Moreover, the last decoding unit DU5 of the first decoding stage DS1 is configured to provide the output command D-cmd1 for operating the first switching unit SwU1. Similarly, the further decoding unit DU6 of the second decoding stage DS2 is configured to provide the output command D-cmd2 for operating the second switching unit SwU2 via the scheduler Scd.

Both the first queue HQ and the second queue SQ are preferably FIFO (First In First Out) queues. The cells of the first queue HQ are configured to store decoded symbols HI associated to the input data blocks B and computed at the first decoding stage DS1 or at the second decoding stage DS2, so that the FEC decoder is capable of outputting them in a transmission order corresponding to the order according to which input data block are received at the FEC decoder, as it will be explained in greater detail herein after. In case a BPSK modulation is considered, each decoded symbol HI is a bit.

According to the preferred embodiment of the present invention, the cells of the second queue SQ are configured to store soft information SI associated to the symbols of the output data blocks B' at the output of the first decoding stage DS1, as it will be explained in greater detail herein after. As soft information has a greater size than decoded symbols, according to this embodiment, the size of the cells of the second queue SQ is higher than the size of the cells of the first queue HQ

According to the further embodiment cited above, the cells of the second queue SQ are configured to store decoded symbols of the output data blocks B' at the output of first decoding stage DS1, as it will be explained in greater detail herein after. According to this embodiment the size of the cells of the first queue HQ and the size of the cells of the second queue SQ are substantially the same.

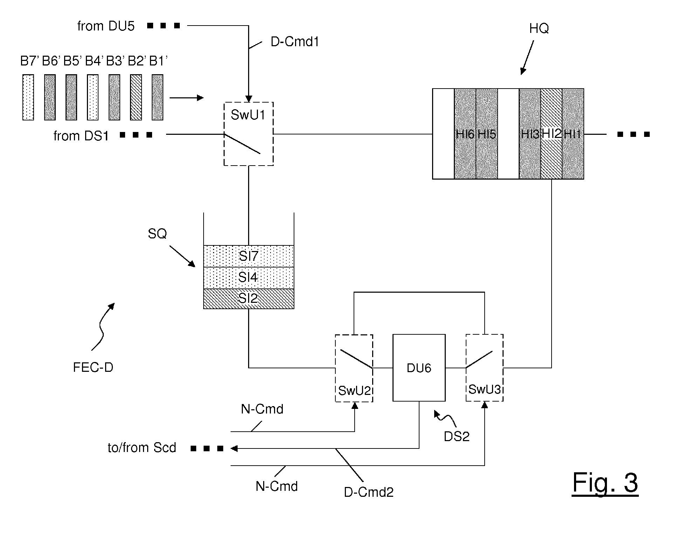

The operation of the FEC decoder FEC-D according to the preferred embodiment of the present invention will be described in the following in relation to Figures 2 and 3. In Figure 2, a number of five decoding unit are shown. This is not limiting since the following description applies to any integer number of decoding units.

As shown in Figure 2, at the input of the FEC decoder FEC-D a sequence of input data blocks B is presented as the result of the processing performed by a demodulator comprised within the receiver (the demodulator and the receiver are not shown in the Figures). The data blocks B are processed by the first decoding stage DS1 comprising the cascade of five decoding units DU1, ..., DU5 of Figure 2. Each decoding unit DU1, ..., DU5 processes one input data block B at a time. In the following, for sake of clarity, reference will be made to the processing of a single data block B.

The data block B is first processed by the first decoding unit DU1, then by the second decoding unit DU2 and so on, until it is processed by the last decoding unit DU5 within the first decoding stage DS1. At each decoding unit DU1, DU2, ..., DU4, DU5 the soft information SI associated to the symbols of the input data block B are updated and decoded symbols HI for the input data block B are generated. The last decoding unit DU5 of the first decoding stage DS1 preferably outputs an output data block B', said output data block B' comprising the decoded symbols HI and the soft information SI associated to the symbols of the input data block B at the last decoding unit DU5 of the first decoding stage DS1.

Preferably, at the last decoding unit DU5 of the first decoding stage DS1 correctness of the decoded symbols is checked on the basis of one or more correctness criteria based on an internal status of the decoding unit DU5. Preferably, for an LDPC code, the correctness criterion considered within the decoding unit DU5 is the parity check.

In the following, the adjective "correct" referred to decoded symbols computed at the last decoding unit of the first decoding stage or at the decoding unit of the second decoding stage will indicate that decoded symbols satisfy the one or more correctness criteria. This same situation will be referred to also by the wording "the output data block is correct". Instead, the situation in which decoded symbols computed at the last decoding unit of the first decoding stage or at the decoding unit of the second decoding stage do not satisfy the one or more correctness criteria will be referred to as "decoded symbols still contain a number of errors" or "decoded symbols are not correct" or "the output data block is not correct".

Then, at the last decoding unit DU5, a command D-cmd1 is preferably outputted towards the first switching unit SwU1 after the input data block B is processed. The output command D-cmd1 of the decoding unit DU5 preferably operates the switching unit SwU1 so that in case the decoded symbols of the output data block B' are correct, the input of the first switching unit SwU1 is connected to the input of the first queue HQ and the decoded symbols HI of the output data block B' are sent to the first queue HQ.

If the decoded symbols of the output data block B' still contains a number of errors, the output command D-cmd1 of the decoding unit DU5 preferably operates the first switching unit SwU1 so that its input is connected to the input of the second queue SQ and the output data block B', in particular the soft information SI updated at the last decoding unit DU5 of the first decoding stage DS1, is sent to the second queue SQ. Moreover, the cells of the first queue HQ that would have been allocated for storing the decoded symbols of the considered output data block B' are left empty.

Alternatively, the first switching unit SwU1 may be operated for connecting the output of the first decoding unit DS1 to both the input of the first queue HQ and the input of the second queue SQ. In this case, the output data block B', in particular the soft information SI updated at the last decoding unit DU5 of the first decoding stage DS1, is sent to the second queue SQ, while the decoded symbols HI at the output of the first decoding stage DS1 are sent to the first queue HQ and stored in the allocated cells, even if the decoded symbols contain errors. These decoded symbols are overwritten after the soft information SI are processed by the second decoding stage, as it will be described in greater detail herein after.

If the second decoding stage DS2 is currently sleeping (i.e. it is not currently processing any soft information), the scheduler Scd operates the second switching unit SwU2 so as to connect the output of the second queue SQ to the input of the second decoding stage DS2.

Then, in this case, the second queue SQ sends to the second decoding stage DS2, namely to the further decoding unit DU6 of Figure 2, the soft information SI updated at the last decoding unit DU5 of the first decoding stage DS1. The further decoding unit DU6 preferably processes the soft information SI in the same manner as described above in relation with each decoding unit DU1, ..., DU5.

In particular, after processing the soft information SI related to the output data block B' and generating decoded symbols, the further decoding unit DU6 checks the correctness of the decoded symbols on the basis of the one or more correctness criteria cited above. Then, the further decoding unit DU6 preferably outputs the command D-cm2 towards the scheduler Scd. Preferably, in case the decoded symbols HI are correct, the output command D-cmd2 comprises an indication that the decoded symbols are correct.

If the decoded symbols at the output of the further decoding unit DU6 are correct, the scheduler Scd, upon reception of the output command D-cmd2, preferably operates the second switching unit SwU2 and the third switching unit SwU3, by means of the command N-cmd, so that the output of the second decoding stage DS2 is connected to the further input of the first queue HQ and the input of the second decoding stage DS2 is connected to the output of the second queue SQ (this input/output configuration of the second decoding stage DS2 will be also referred to as "first configuration"). This way, decoded symbols at the output of the further decoding unit DU6 are sent to the first queue HQ, while the soft information of a subsequent output data block within the second queue SQ are sent to the input of the further decoding unit DU6.

If the decoded symbols at the output of the further decoding unit DU6 still contain errors, the scheduler Scd, upon reception of the output command D-cmd2, preferably operates the second switching unit SwU2 and the third switching unit SwU3, by means of the command N-cmd, so that the output of the second decoding stage DS2 is retroactively connected to its input (this input/output configuration of the second decoding stage DS2 will be also referred to as "second configuration"). This way, the updated soft information SI are sent again at the input of the further decoding unit DU6 and processed again. Preferably, the operations performed by the further decoding unit DU6 on the soft information SI of the considered output data block B' are iteratively performed until at least one termination condition is fulfilled, as it will be described in greater detail herein after. The soft information SI are updated at each iteration.

Each time the further decoding unit DU6 performs an iteration, decoded symbols HI are generated and the command D-cmd2 is outputted towards the scheduler Scd.

It is to be noticed that, even if in Figure 2 the same notation "SI" is used for indicating the soft information at the output of the first decoding stage DS1 (and at the output of the second queue SQ) and at the output of the further decoding unit DU6 (along the feed-back loop), for a considered output data block B', these soft information are updated each time an iteration of the soft iterative FEC decoding procedure is performed at the further decoding unit DU6. Similarly, even if in Figure 2 the same notation "HI" is used for indicating the decoded symbols at the output of the first decoding stage DS1 and at the output of the further decoding unit DU6, for a considered output data block B', these decoded symbols are generated each time an iteration of the soft iterative FEC decoding procedure is performed at the further decoding unit DU6.

Preferably, the second queue SQ periodically generates a queue status information SQ-St indicative of a filling level thereof. Preferably, the queue status information SQ-St is periodically sent to the scheduler Scd.

The operations performed by the scheduler Scd are described in more detail in the following. Preferably, periodically, the scheduler Scd receives the queue status information SQ-St from the second queue SQ. Moreover, the scheduler Scd preferably receives the command D-cmd2 from the further decoding unit DU6 each time an iteration is performed by the further decoding unit DU6. Preferably, the scheduler Scd checks one or more termination conditions according to which the iterative processing of the soft information SI related to an output data block B' by the further decoding unit DU6 is to be stopped, and the soft information related to a subsequent output data block stored in the second queue SQ may be processed by the further decoding unit DU6. The termination condition may be:

  i) the decoded symbols HI at the output of the further decoding unit DU6 at the current iteration are correct; and/or
  ii) the second queue SQ reaches a threshold filling level, and/or
  iii) the time of the iterations performed by the further decoding unit DU6 on the soft information SI of the considered output data block B' exceeds a maximum elaboration time.

In particular, if the scheduler Scd receives from the further decoding unit DU6 the command D-cmd2 with the indication that the decoded symbols are correct, it establishes that condition i) is fulfilled and then it sends the command N-cmd to the third switching unit SwU3 so that the output of the further decoding unit DU6 is connected to the further input of the first queue HQ. Substantially at the same time, the scheduler Scd sends the same command N-cmd to the second switching unit SwU2 so that the input of the second decoding stage DS2 is connected to the output of the second queue SQ.

On the other hand, condition ii) is fulfilled if the scheduler Scd, by comparing the filling level of the second queue SQ indicated in the queue status information SQ-St to the threshold filling level, establishes that the current filling level of the second queue SQ exceeds the threshold filling level. In this case, even if the decoded symbols HI at the output of the further decoding unit DU6 still contain errors, the scheduler Scd sends the command N-cmd to the third switching unit SwU3 so that the output of the further decoding unit DU6, is connected to the further input of the first queue HQ. Substantially at the same time, the scheduler Scd sends the same command N-cmd to the second switching unit SwU2 so that the input of the second decoding stage DS2 is connected to the output of the second queue SQ.

Condition iii) is fulfilled if the scheduler Scd establishes that the time of the iterations performed by the further decoding unit DU6 exceeds the maximum elaboration time. The maximum elaboration time depends substantially on the length of the first queue HQ and on the filling level of the second queue SQ. Indeed, the length of the first queue HQ determines a fixed delay according to which the decoded symbols associated to each input data block B are outputted by the FEC decoder. This fixed delay substantially corresponds to a fixed number of iterations that may be performed by the further decoding unit on all the soft information stored within the second queue SQ and related to one or more output data blocks B'. Therefore, if the second queue SQ stores the soft information of one output data block B', the maximum elaboration time for the considered output data block B' is substantially equal to the fixed delay introduced by the first queue HQ. If the second queue SQ stores the soft information of a number of output data blocks B', the fixed delay (and the fixed number of iterations of the further decoding unit DU6) is preferably subdivided between the number of output data blocks B', so that for each output data block B' the maximum elaboration time is a fraction of the fixed delay. For instance, the fixed delay may be equally divided for processing, at the second decoding stage DS2, the soft information related to the number of output data blocks B' stored within the second queue SQ. In other words, the same maximum elaboration time may be considered for each output data block B' sent to the second queue SQ.

In all cases, when one or more termination conditions are fulfilled, the decoded symbols HI at the output of the second decoding stage DS2 are sent to the first queue HQ. Then, the decoded symbols HI are put into the cells of the first queue HQ which have been left empty when, at the first switching unit SwU1, the soft information SI of the output data block B' was switched to the second queue SQ. According to the alternative embodiment described above, the decoded symbols HI at the output of the second decoding stage DS2 overwrite the incorrect decoded symbols of the output data block B' that were stored in the first queue HQ after the last iteration of the first decoding stage DS1. This way, the decoded symbols HI are always stored in the first queue HQ in a position that preserves the ordering of the input data blocks B. In other words, the decoded symbols stored within the first queue HQ "wait" to be outputted by the FEC decoder at the right time allowing to preserve the ordering according to which the input data blocks B are received at the FEC decoder.

In this respect, it is to be noticed that the maximum elaboration time defined above is the time limit within which the decoded symbols HI at the output of the further decoding unit DU6 may be introduced in the first queue HQ without loosing the input data block ordering.

Preferably, the number of decoding units within the first decoding stage DS1 and the size of the first queue HQ and the second queue SQ are preferably chosen so that a probability of outputting incorrect codewords by the FEC decoder FEC-D (also referred to as output WER, word error rate) is less than a pre-determined target value. The output WER target value may be equal to about $10^{-12}$.

In particular, the number of decoding units of the first decoding stage DS1 and the size of the second queue SQ are preferably chosen on the basis of an indication concerning the fraction of corrected n-symbol data blocks versus the number of needed iterations for the considered FEC code and the considered output BER. For instance, considering the histogram shown in Figure 1 for the exemplary LDPC code described above, if a number of five decoding units is chosen, about 0.1% data blocks at the output of the first decoding stage DS1 are incorrect. According to the present invention, these output data blocks are transferred to the second queue SQ for sending them to the second decoding stage DS2. Hence, the size of the second queue SQ is preferably chosen so that the second decoding stage DS2 may process all the output data blocks stored within the second queue SQ for giving an output WER less than the target value, e.g. less than $10^{-12}$. In other words, the size of the second queue SQ is chosen so as to avoid overflow, which would lead to a probability of outputting incorrect codewords higher than the output WER target value. If, instead, a number of six decoding units is chosen for the first decoding stage DS1, the size of the second queue SQ may be lower, as less output data blocks would be transferred to the second queue SQ.

In Figure 3, an exemplary situation is depicted in which seven input data blocks B1, B2, ..., B7 (not shown in the Figure) are presented at the input of the FEC decoder. The first decoding stage DS1 provides seven output data blocks B1', B2', ..., B7'. It is assumed that after the first input data block B1 is processed by the decoding unit DU5, the decoded symbol of the first output data block B1' are correct and the command D-cmd1 outputted by the decoding unit DU5 operates the first switching unit SwU1 to connect its input to the input of the first queue HQ and hence to send the decoded symbols HI1 of the first output data block B1' provided by the last decoding unit DU5 of the first decoding stage DS1 to the first queue HQ. The first queue HQ preferably stores the decoded symbols HI1 of the first output data block B1' in one or more cells labeled "HI1" as depicted in Figure 3. Further, it is assumed that after the second input data block B2 is processed by the decoding unit DU5, the decoded symbols of the second output data block B2' still contains errors and hence the command D-cmd1 outputted by the decoding unit DU5 operates the first switching unit SwU1 to connect its input to the input of the second queue SQ. In this case, the switching unit SwU1 sends to the second queue SQ the soft information SI2 associated to the second output data block B2' outputted after the fifth iteration of the considered iterative FEC decoding procedure. The second queue SQ preferably stores the soft information SI2 of the second output data block B2' in one or more cells, which are labeled by "SI2" in Figure 3. In the meanwhile, in the exemplary situation represented in Figure 3, the cells in the first queue HQ that would have been used for storing the decoded symbols of the second output data block B2' are left empty. In other words, in the first queue HQ a number of cells are left empty when the soft information SI2 of the second output data block B2' are sent to the second queue SQ, this number of cells being substantially equal to the number of cells needed for storing the decoded symbols related to the second output data block B2'. These empty cells are in a subsequent adjacent position with respect to the cells used for storing the decoded symbols of the first output data block B1' and are represented in Figure 3 by white slots.

The scheduler Scd operates the second switching unit SwU2 so that it connects the output of the second queue SQ to the input of the second decoding stage DS2. This way, the soft information SI2 of the second output data block B2' at the output of the fifth decoding unit DU5 are sent to the further decoding unit DU6. At the further decoding unit DU6 the soft information SI2 are processed and, if the decoded symbols of the second output data block B2' still contains errors, the soft information SI2 is updated and retroactively sent again to the further decoding unit DU6 for undergoing a second iteration. This procedure is possibly further iterated until a termination condition is fulfilled.

In the meanwhile, the other input data blocks B3, ..., B7 are processed by the FEC decoder in the same manner as described above. In particular, input data blocks B3,..., B7 are processed by the first decoding stage DS1 and:

- the decoded symbols HI3, HI5 and HI6 of the output data blocks B3', B5' and B6', respectively, are sent to the first queue HQ and stored in corresponding cells, as represented in Figure 3;
- the soft information SI4 and SI7 of the output data blocks B4' and B7', respectively, are sent to the second queue SQ and stored in corresponding cells as represented in Figure 3. In the meanwhile, in the first queue HQ, empty cells are provided in the position in which decoded symbols from the fourth output data block B4' would have been stored, and in the position in which decoded symbols from the seventh output data block B7' would have been stored, for preserving the ordering of input data blocks. These empty cells are represented in Figure 3 by white slots in the first queue HQ.

As described above, iterations performed by the further decoding unit DU6 may end when one or more of the termination conditions described above are fulfilled. For instance, iterations performed by the further decoding unit DU6 on the soft information SI2 of the second output data block B2' may end when the decoded symbols HI computed at the further decoding unit DU6 are correct. In this case, the further decoding unit DU6 outputs a command D-cmd2 directed to the scheduler Scd, which, in its turn, outputs a command N-cmd directed to the second switching unit SwU2 and to the third switching unit SwU3, so that the second switching unit SwU2 and the third switching unit SwU3 are operated so as to connect the output of the second decoding stage DS2 to the further input of the first queue HQ and the input of the second decoding stage DS2 to the output of the second queue SQ.

Moreover, iterations at the further decoding unit DU6 may end when the second queue SQ reaches a threshold filling level, irrespective of the fact that the computed decoded symbols HI2 are correct. The scheduler Scd periodically compares the filling level of the second queue SQ with the threshold filling level and in case the current filling level exceeds the threshold filling level it outputs the command N-cmd directed to the second switching unit SwU2 and to the third switching unit SwU3, as described above.

Further, iterations at the further decoding unit DU6 may end when the time taken by these iterations exceeds a maximum elaboration time which, as described above, substantially depends on the length of the first queue HQ and on the filling level of the second queue SQ. Also in this case, iterations may stop irrespective of the fact that the computed decoded symbols HI2 are correct.

The decoded symbols HI2 generated at the end of the iterations performed by the further decoding unit DU6 are sent to the first queue HQ and inserted in the cells that were left empty in a subsequent adjacent position with respect to the cells storing the decoded symbols HI1 of the first output data block B1'. In Figure 3 these cells are represented by the slot labeled "HI2". At substantially the same time, the further decoding unit DU6 starts processing the soft information stored in the subsequent cells (labeled by "SI4" in Figure 3) within the second queue SQ, namely the soft information SI4 of the fourth output data block B4', which is then processed in exactly the same manner as described above with reference to the second output data block B2'.

Similar operations as those described above are performed for each input data block at the input of the FEC decoder.

The operations of the FEC decoder according to the present invention have been described in the foregoing with reference to the preferred embodiment, according to which each decoding unit performs an iteration of an iterative soft decision FEC decoding procedure. The operations of the FEC decoder according to the further embodiment, wherein each decoding unit perform an iteration of an iterative hard decision FEC decoding procedure are similar, except for the fact that the processing performed by each decoding unit involves, as known, the decoded symbols and not the soft information associated to the data block. Hence, according to this further embodiment, the output data blocks at the output of the last decoding unit DU5 of the first decoding stage DS1 contain the decoded symbols and as already described above, the second queue SQ does not store soft information but it stores those decoded symbols at the output of the last decoding unit DU5 of the first decoding stage DS1.

The FEC decoder according to the present invention has a number of advantages. In particular, the FEC decoder according to the present invention allows implementing a variable number of iterations per each data block. This is advantageously very efficient. Indeed, since, as discussed above, a low number of iterations are typically necessary to decode a data block while only very few data blocks require an exceptionally high number of iterations, it follows that the FEC decoder according to the present invention allows reducing the number of decoding units with respect to state of the art solutions. As apparent, the FEC decoder according to the present invention allows greatly reducing the power consumption of the FEC decoder and the amount of the required silicon area with respect to state of the art decoders. The reduction may be almost equal to 50%. This is particularly useful for integrating the components of the FEC decoder in a single chip for high speed systems, e.g. working at 100/400/500 Gb/s, where constraints on the area and power consumption of the chip are critical.

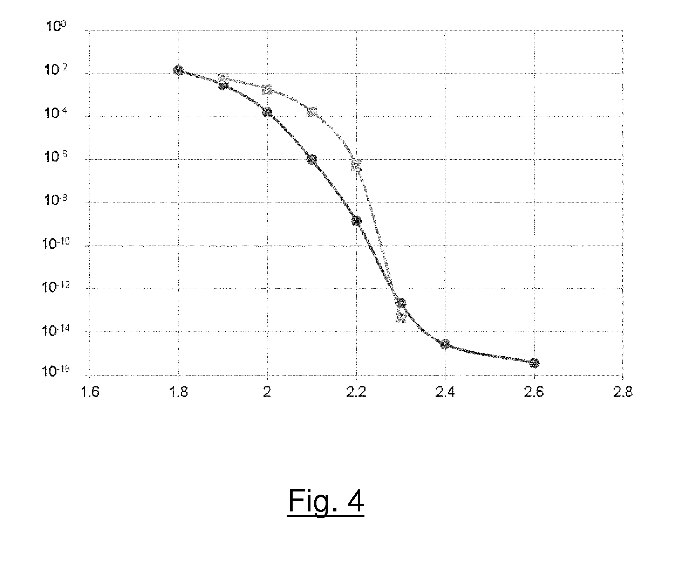

Figure 4 is a graph showing the BER achieved by the FEC decoder of the present invention (grey curve) as a function of the SNR expressed in dB, for the exemplary LDPC code described above. In the same Figure, the BER achieved by the state of the art decoder with 12 fixed decoding units is also represented (black curve), as a function of the SNR expressed in dB. As can be appreciated, in the region of BER lower than $10^{-14}$ (which, as mentioned above, is the region of interest for high speed WDM network implementations), the FEC decoder of the present invention allows achieving better performances than the state of the art decoder as the BER curve is much steeper and does not show any error floor. Therefore, for the exemplary LDPC code, the FEC decoder of the present invention allows not only significantly reducing the number of decoding units but also achieving better performances than the decoder with 12 fixed decoding units within the region of interest for high speed implementations.

Moreover, the power consumption is kept almost constant irrespective of the considered SNR. Indeed, the power variation is exclusively due to the fact that, while the decoding units of the first decoding stage permanently work and consume power during operation of the FEC decoder, the further decoding unit may work or not on the basis of the fact that data blocks are passed to the second queue (i.e. data blocks still contain errors after five iterations). Therefore, the power variation within the FEC decoder of the present invention is due to only one decoding unit out of six decoding units, in the exemplary FEC decoder of Figures 2 and 3, and therefore may be kept under control. Other schemes of iterative decoding that provide for a variable number of iterations for each data block may result in FEC decoders whose power highly fluctuates depending on the considered SNR, causing problems in power supply and in dimensioning the power dissipation.

Moreover, the FEC decoder according to the present invention allows optimizing the connectivity between the decoding units, i.e. it allows minimizing the length of the connections and allows keeping connectivity between the decoding units very simple. This FEC decoder is hence particularly suitable for implementation in very high bit rate systems wherein chip layout is to be optimized.

Furthermore, the FEC decoder according to the present invention allows balancing the latency according to which a data block is processed and outputted by the FEC decoder versus a maximum number of iterations that a data block may undergo. This is simply done by adjusting the delay introduced by the first queue, i.e. by adjusting the size of such queue, which size is very small due to the fact that this queue stores the decoded symbols. In the FEC decoder according to the present invention a data block may undergo even more than 12 iterations at the relatively low cost of increasing the size of the first and second queues.

It is to be noticed that, while reference has been made to LDPC codes, the FEC decoder of the present invention is not limited to decode such type of codes but it can be implemented for the iterative decoding (both iterative hard decision decoding and iterative soft decision decoding) of different types of FEC codes similarly to what has been described above.

According to other embodiments of the present invention (not shown in the Figures), a number of further decoding units is comprised within the second decoding stage of the FEC decoder, such number being higher than 1. According to these embodiments, the further decoding units are placed in parallel at the output of the second queue SQ. Each further decoding unit preferably processes the soft information related to one data block in substantially the same manner described above with reference to the further decoding unit of Figures 2 and 3. In this case, the soft information related to different data blocks are processed in parallel.

Advantageously, providing more than one further decoding unit in parallel allows increasing the rate at which the second queue empties and hence allows increasing the processing rate achieved by the FEC decoder

The functions of the various elements shown in the Figures 2 and 3, including any functional blocks labeled as "device", "unit", "block" or "processing unit", may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the terms "processing unit", "device", "block" or "unit" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non volatile storage. Other hardware, conventional and/or custom, may also be included.

## Claims

1. A forward error correction decoder (FEC-D) for a network element of a communication network, said forward error correction decoder (FEC-D) comprising:

   - a first decoding stage (DS1) configured to receive an input data block (B), said first decoding stage comprising a plurality of decoding units (DU1, ..., DU5) connected in cascade, each of said decoding units (DU1, ..., DU5) being configured to perform one iteration of a forward error correction decoding procedure on said input data block (B), said first decoding stage being further configured to output an output data block (B'); and
   - a second decoding stage (DS2) comprising a further decoding unit (DU6) configured to:

     - receive the output data block (B') in case said output data block (B') is not correct; and
     - perform a number of further iterations of said forward error correction decoding procedure on said output data block (B') until a termination condition is fulfilled, said number of further iterations being equal to or higher than 1.

2. The forward error correction decoder (FEC-D) according to claim 1, wherein it comprises a first queue (HQ) and a second queue (SQ), wherein said first decoding stage (DS1) is configured to send decoded symbols of said output data block (B') to said first queue (HQ) in case said output data block (B') is correct, and to send soft information of said output data block (B') to said second queue (SQ) in case said output data block (B') is not correct, said second queue (SQ) having an output configured to be connected to said second decoding stage (DS2).

3. The forward error correction decoder (FEC-D) according to claim 1, wherein it comprises a first queue (HQ) and a second queue (SQ), wherein said first decoding stage is configured to send decoded symbols of said output data block (B') to said first queue (HQ) in case said output data block (B') is correct, and to send said decoded symbols of said output data block (B') to said second queue (SQ) in case said output data block (B') is not correct, said second queue (SQ) having an output configured to be connected to said second decoding stage (DS2).

4. The forward error correction decoder (FEC-D) according to claim 2 or 3, wherein it comprises a scheduler (Scd) configured to command switching an input and an output of said second decoding stage (DS2) between a first configuration and a second configuration, wherein:

    - said first configuration provides for connecting said input of said second decoding stage (DS2) to said second queue (SQ) and said output of said second decoding stage (DS2) to said first queue (HQ); and
    - said second configuration provides for retroactively connecting said output of said second decoding stage (DS2) to said input of said second decoding stage (DS2).

5. The forward error correction decoder (FEC-D) according to claim 4, wherein said scheduler (Scd) is configured to check whether said termination condition is fulfilled and, in case said termination condition is fulfilled, to command switching said input and said output of said second decoding stage (DS2) from said second configuration to said first configuration.

6. The forward error correction decoder (FEC-D) according to claim 5, wherein said scheduler (Scd) is connected to said second queue (SQ) and to said second decoding stage (DS2) and it is further configured to

    - receive an information on a filling status (SQ-St) of said second queue (SQ) from said second queue (SQ);
    - receive a command (D-cmd2) from said second decoding stage (DS2) each time said further decoding unit (DU6) performs one further iteration; and
    - on the basis of said filling status (SQ-St) and said command (D-cmd2), check whether said termination condition is fulfilled by:
    - checking whether at a current further iteration performed by said further decoding unit (DU6) said output data block (B') is correct; and/or
    - checking whether said second queue (SQ) has reached a threshold filling level; and/or
    - checking whether a maximum elaboration time elapsed during said performing said number of further iterations.

7. A receiver for a network element of a communication network comprising the forward error correction decoder (FEC-D) according to claims 1 to 6.

8. A network element of a communication network comprising a receiver according to claim 7.

9. A method for decoding an input data block (B) encoded through a forward error correction code, said method comprising:

    a) at a plurality of decoding units of a first decoding stage (DS1), receiving said input data block (B), performing a plurality of cascaded iterations of a forward error correction decoding procedure on said input data block (B), and outputting an output data block (B'); and
    b) at a further decoding unit (DU6) of a second decoding stage (DS2), receiving said output data block (B') in case said output data block (B') is not correct, and performing a number of further iterations of said forward error correction decoding procedure on said output data block (B') until a termination condition is fulfilled, said number of further iterations being equal to or higher than 1.

10. The method according to claim 9, wherein it further comprises sending decoded symbols of said output data block (B') to a first queue (HQ) in case said output data block (B') is correct, and, between step a) and step b), sending soft information of said output data block (B') to a second queue (SQ) in case said output data block (B') is not correct, wherein at step b) said receiving comprises receiving said soft information of said output data block (B') from said second queue (SQ).

11. The method according to claim 9, wherein it further comprises sending decoded symbols of said output data block (B') to a first queue (HQ) in case said output data block (B') is correct, and between step a) and step b), sending said decoded symbols of said output data block (B') to a second queue (SQ) in case said output data block (B') is not correct, wherein at step b) said receiving comprises receiving said decoded symbols of said output data block (B') from said second queue (SQ).

12. The method according to claim 10 or 11, wherein it comprises, at a scheduler (Scd) connected to said second queue (SQ) and to said second decoding stage (DS2), receiving an information on a filling status (SQ-St) of said second queue (SQ) from said second queue (SQ), receiving a command (D-cmd2) from said second decoding stage (DS2) each time one further iteration is performed and checking whether said termination condition is fulfilled, said checking comprising:

    - checking whether at a current further iteration performed by said further decoding unit (DU6) said output data block (B') is correct; and/or
- checking whether said second queue (SQ) has reached a threshold filling level; and/or
- checking whether a maximum elaboration time elapsed during said performing said number of further iterations.

13. The method according to claim 12, wherein it comprises, when said termination condition is fulfilled, sending decoded symbols of said output data block (B') generated at said second decoding stage (DS2) to said first queue (HQ).

14. The method according to claim 13, wherein it further comprises, before said step b), in case said output data block (B') is not correct, leaving a number of cells empty within said first queue (HQ).

15. The method according to claim 14, wherein it comprises, at said first queue (HQ), storing said decoded symbols of said output data block (B') generated at said second decoding stage (DS2) into said empty cells of said first queue (HQ).

**Amended claims in accordance with Rule 137(2) EPC.**

1. A forward error correction decoder (FEC-D) for a network element of a communication network, said forward error correction decoder (FEC-D) comprising:

   - a first decoding stage (DS1) configured to receive an input data block (B), said first decoding stage comprising a plurality of decoding units (DU1, ..., DU5) connected in cascade, each of said decoding units (DU1, ..., DU5) being configured to perform one iteration of a forward error correction decoding procedure on said input data block (B), said first decoding stage being further configured to output an output data block (B'); and
   - a second decoding stage (DS2) comprising a further decoding unit (DU6) configured to:

      - receive the output data block (B') in case said output data block (B') is not correct; and
      - perform a further iteration of said forward error correction decoding procedure on said output data block (B') and, if decoded symbols at the output of said further decoding unit (DU6) still contain errors, perform a number of still further iterations of said forward error correction decoding procedure on said output data block (B') until a termination condition is fulfilled, said number of still further iterations being equal to or higher than 1.

2. The forward error correction decoder (FEC-D) according to claim 1, wherein it comprises a first queue (HQ) and a second queue (SQ), wherein said first decoding stage (DS1) is configured to send decoded symbols of said output data block (B') to said first queue (HQ) in case said output data block (B') is correct, and to send soft information of said output data block (B') to said second queue (SQ) in case said output data block (B') is not correct, said second queue (SQ) having an output configured to be connected to said second decoding stage (DS2).

3. The forward error correction decoder (FEC-D) according to claim 1, wherein it comprises a first queue (HQ) and a second queue (SQ), wherein said first decoding stage is configured to send decoded symbols of said output data block (B') to said first queue (HQ) in case said output data block (B') is correct, and to send said decoded symbols of said output data block (B') to said second queue (SQ) in case said output data block (B') is not correct, said second queue (SQ) having an output configured to be connected to said second decoding stage (DS2).

4. The forward error correction decoder (FEC-D) according to claim 2 or 3, wherein it comprises a scheduler (Scd) configured to command switching an input and an output of said second decoding stage (DS2) between a first configuration and a second configuration, wherein:

   - said first configuration provides for connecting said input of said second decoding stage (DS2) to said second queue (SQ) and said output of said second decoding stage (DS2) to said first queue (HQ); and
   - said second configuration provides for retroactively connecting said output of said second decoding stage (DS2) to said input of said second decoding stage (DS2).

5. The forward error correction decoder (FEC-D) according to claim 4, wherein said scheduler (Scd) is configured to check whether said termination condition is fulfilled and, in case said termination condition is fulfilled, to command switching said input and said output of said second decoding stage (DS2) from said second configuration to said first configuration.

6. The forward error correction decoder (FEC-D) according to claim 5, wherein said scheduler (Scd) is connected to said second queue (SQ) and to said second decoding stage (DS2) and it is further configured to

   - receive an information on a filling status (SQ-St) of said second queue (SQ) from said second queue (SQ);

- receive a command (D-cmd2) from said second decoding stage (DS2) each time said further decoding unit (DU6) performs one further iteration; and
- on the basis of said filling status (SQ-St) and said command (D-cmd2), check whether said termination condition is fulfilled by:

  - checking whether at a current further iteration performed by said further decoding unit (DU6) said output data block (B') is correct; and/or
  - checking whether said second queue (SQ) has reached a threshold filling level; and/or
  - checking whether a maximum elaboration time elapsed during said performing said number of further iterations.

7. A receiver for a network element of a communication network comprising the forward error correction decoder (FEC-D) according to claims 1 to 6.

8. A network element of a communication network comprising a receiver according to claim 7.

9. A method for decoding an input data block (B) encoded through a forward error correction code, said method comprising:

   a) at a plurality of decoding units of a first decoding stage (DS1), receiving said input data block (B), performing a plurality of cascaded iterations of a forward error correction decoding procedure on said input data block (B), and outputting an output data block (B'); and
   b) at a further decoding unit (DU6) of a second decoding stage (DS2), receiving said output data block (B') in case said output data block (B') is not correct, performing a further iteration of said forward error correction decoding procedure on said output data block (B') and, if decoded symbols at the output of said further decoding unit (DU6) still contain errors, performing a number of still further iterations of said forward error correction decoding procedure on said output data block (B') until a termination condition is fulfilled, said number of still further iterations being equal to or higher than 1.

10. The method according to claim 9, wherein it further comprises sending decoded symbols of said output data block (B') to a first queue (HQ) in case said output data block (B') is correct, and, between step a) and step b), sending soft information of said output data block (B') to a second queue (SQ) in case said output data block (B') is not correct, wherein at step b) said receiving comprises receiving said soft information of said output data block (B') from said second queue (SQ).

11. The method according to claim 9, wherein it further comprises sending decoded symbols of said output data block (B') to a first queue (HQ) in case said output data block (B') is correct, and between step a) and step b), sending said decoded symbols of said output data block (B') to a second queue (SQ) in case said output data block (B') is not correct, wherein at step b) said receiving comprises receiving said decoded symbols of said output data block (B') from said second queue (SQ).

12. The method according to claim 10 or 11, wherein it comprises, at a scheduler (Scd) connected to said second queue (SQ) and to said second decoding stage (DS2), receiving an information on a filling status (SQ-St) of said second queue (SQ) from said second queue (SQ), receiving a command (D-cmd2) from said second decoding stage (DS2) each time one further iteration is performed and checking whether said termination condition is fulfilled, said checking comprising:

    - checking whether at a current further iteration performed by said further decoding unit (DU6) said output data block (B') is correct; and/or
    - checking whether said second queue (SQ) has reached a threshold filling level; and/or
    - checking whether a maximum elaboration time elapsed during said performing said number of further iterations.

13. The method according to claim 12, wherein it comprises, when said termination condition is fulfilled, sending decoded symbols of said output data block (B') generated at said second decoding stage (DS2) to said first queue (HQ).

14. The method according to claim 13, wherein it further comprises, before said step b), in case said output data block (B') is not correct, leaving a number of cells empty within said first queue (HQ).

15. The method according to claim 14, wherein it comprises, at said first queue (HQ), storing said decoded symbols of said output data block (B') generated at said second decoding stage (DS2) into said empty cells of said first queue (HQ).

Fig. 1

Fig. 2

Fig. 3

## Fig. 4

Europäisches
Patentamt

European
Patent Office

Office européen
des brevets

# EUROPEAN SEARCH REPORT

Application Number

EP 13 30 5884

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 976 128 A1 (HITACHI GLOBAL STORAGE TECH [NL]) 1 October 2008 (2008-10-01) * paragraph [0088] - paragraph [0097]; figure 7 * | 1-3,7-11 | INV. H03M13/11 |
| X | EP 2 114 014 A2 (LSI CORP [US]) 4 November 2009 (2009-11-04) * paragraph [0036] - paragraph [0041]; figure 3a * | 1-3,7-11 | |
| X | WO 2009/124376 A1 (NORTEL NETWOKS LTD [CA]; ROBERTS KIM B [CA]) 15 October 2009 (2009-10-15) * paragraph [0043] - paragraph [0047]; figure 7 * | 1,3,7-9, 11 | |
| X | US 6 654 927 B1 (SALL MIKHAIL A [RU] ET AL) 25 November 2003 (2003-11-25) * column 3, line 44 - column 5, line 16; figure 1 * | 1-3,7-11 | |
| A | DE 102 14 393 A1 (UNIV DRESDEN TECH [DE]) 6 February 2003 (2003-02-06) | 1-15 | TECHNICAL FIELDS SEARCHED (IPC) H03M |
| A | EP 1 127 413 A2 (QUALCOMM INC [US]) 29 August 2001 (2001-08-29) | 1-15 | |
| A | DEYUAN CHANG ET AL: "FPGA verification of a single QC-LDPC code for 100 Gb/s optical systems without error floor down to BER of 10 â 15", OPTICAL FIBER COMMUNICATION CONFERENCE, 2011. TECHNICAL DIGEST. OFC/NFOEC, IEEE, 6 March 2011 (2011-03-06), pages 1-3, XP031946558, ISBN: 978-1-4577-0213-6 | 1-15 | |
| A | US 2013/091399 A1 (HU JUNQIANG [US] ET AL) 11 April 2013 (2013-04-11) | 1-15 | |

The present search report has been drawn up for all claims

| Place of search | Date of completion of the search | Examiner |
|---|---|---|
| Munich | 5 September 2013 | Farman, Thomas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 13 30 5884

This annex lists the patent family members relating to the patent documents cited in the above-mentioned European search report.
The members are as contained in the European Patent Office EDP file on
The European Patent Office is in no way liable for these particulars which are merely given for the purpose of information.

05-09-2013

| Patent document cited in search report | | | Publication date | Patent family member(s) | | | Publication date |
|---|---|---|---|---|---|---|---|
| EP | 1976128 | A1 | 01-10-2008 | CN | 101276627 | A | 01-10-2008 |
| | | | | EP | 1976128 | A1 | 01-10-2008 |
| | | | | JP | 2008257842 | A | 23-10-2008 |
| | | | | KR | 20080089162 | A | 06-10-2008 |
| | | | | SG | 146531 | A1 | 30-10-2008 |
| | | | | TW | 200844729 | A | 16-11-2008 |
| | | | | US | 2008244359 | A1 | 02-10-2008 |
| EP | 2114014 | A2 | 04-11-2009 | CN | 101572553 | A | 04-11-2009 |
| | | | | EP | 2114014 | A2 | 04-11-2009 |
| | | | | JP | 2009273123 | A | 19-11-2009 |
| | | | | KR | 20090115677 | A | 05-11-2009 |
| | | | | TW | 201004155 | A | 16-01-2010 |
| | | | | US | 2009273492 | A1 | 05-11-2009 |
| | | | | US | 2012284585 | A1 | 08-11-2012 |
| WO | 2009124376 | A1 | 15-10-2009 | US | 2009256622 | A1 | 15-10-2009 |
| | | | | WO | 2009124376 | A1 | 15-10-2009 |
| US | 6654927 | B1 | 25-11-2003 | KR | 20010069198 | A | 23-07-2001 |
| | | | | US | 6654927 | B1 | 25-11-2003 |
| DE | 10214393 | A1 | 06-02-2003 | NONE | | | |
| EP | 1127413 | A2 | 29-08-2001 | AU | 2146000 | A | 22-05-2000 |
| | | | | CN | 1348631 | A | 08-05-2002 |
| | | | | EP | 1127413 | A2 | 29-08-2001 |
| | | | | JP | 4386588 | B2 | 16-12-2009 |
| | | | | JP | 2002529953 | A | 10-09-2002 |
| | | | | WO | 0027037 | A2 | 11-05-2000 |
| US | 2013091399 | A1 | 11-04-2013 | NONE | | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **B. VASIC ; I.B. DJORDJEVIC ; R.K. KOSTUK.** Low-density parity check codes and iterative decoding for long-haul optical communication systems. *J. Lightwave Technol.,* vol. 21 (2), 438-446